# EUROPEAN PATENT APPLICATION

(11) **EP 4 141 973 A1**
(43) Date of publication of application: **01.03.2023**
(21) Application number: 22191647.1
(22) Date of filing: 23.08.2022
(51) Int. Cl.: H01L 33/48, H01L 33/58

(54) **LIGHT EMITTING DEVICE**

(30) Priority: 24.08.2021 TW 110131327
(71) Applicant: Lextar Electronics Corp., 30075 Hsinchu (TW)
(72) Inventor: CHIANG, Ching-Chi, 30075 Hsinchu (TW); CHEN, Shu-Wei, 30075 Hsinchu (TW); HUNG, Tzu-Yuan, 30075 Hsinchu (TW); WANG, Chun-Wei, 30075 Hsinchu (TW)
(74) Representative: Winter, Brandl - Partnerschaft mbB

(57) **Abstract**

A light-emitting device includes a circuit substrate, a wall, a light-emitting diode chip, a fluorescent resin and a plate. The wall is formed on the circuit substrate to form a concave cup with properties of light transmission and reflection, and has a height of the wall is H2. The light emitting diode chip is die-bonded on the circuit substrate in the concave cup and a height of the light-emitting diode chip is HI. The fluorescent resin is filled in the concave cup and covered over the light-emitting diode chip. The plate is covered on the fluorescent resin and equipped with properties of light transmission and reflection. A maximum thickness of the plate is H3, wherein H3 = A^{∗}(H2/H1) + B, a value of A ranges from 10.5 to 15.5, and a value of B ranges from 0.05 to 131.5.

## Description

### BACKGROUND

### Field of Disclosure

The present disclosure relates to a light emitting device (LED).

### Description of Related Art

Light emitting diode is a light-emitting element made of semiconductor material that can convert electrical energy into light. It has the advantages of small size, high energy conversion efficiency, long life, power saving, etc. Thus, it can be widely used as light source in various electronic applications.

In recent years, there are various new technologies for light-emitting diodes that have been applied to the backlight or lighting industry, and blue light-emitting diodes are also more widely used in backlighting. At present, the light-emitting diodes are designed to use white materials that have a reflective ability to be matched with blue light-emitting diodes, and yellow, red, green and other phosphors mixed in the silicon material to obtain a white light source. The range of lighting angle of this light-emitting diode is produced from 110 degrees to 120 degrees. Due to the optical effect of the fluorescent, the light intensity in the central area is increased and the original light distribution is lost, thereby causing the uneven brightness problem in backlight module.

### SUMMARY

One aspect of the present disclosure is to provide a light emitting device including a circuit substrate, a wall, at least one light-emitting diode chip, a fluorescent resin and a plate. The wall is formed on the circuit substrate to form a concave cup with properties of light transmission and reflection, and a height of the wall is H2 (unit: microns, µm). The at least one light-emitting diode chip is bonded on the circuit substrate and in the concave cup, and a height of the light-emitting diode chip is H1 (unit: microns, µm). The fluorescent resin is filled in the concave cup and covered over the light-emitting diode chip. The plate covers the fluorescent resin and equipped with properties of light transmission and reflection and a maximum thickness of the plate is H3 (unit: microns, µm), wherein H3 = A^{∗}(H2/H1) + B, and a value of A ranges from 10.5 to 15.5, a value of B ranges from 0.05 to 131.5.

It is to be understood that both the foregoing general description and the following detailed description are by examples, and are intended to provide further explanation of the light emitting device as claimed.

### BRIEF DESCRIPTION OF THE DRAWINGS

The light emitting device can be more fully understood by reading the following detailed description of the embodiment, with reference made to the accompanying drawings as follows:
FIG. 1 illustrates a cross-sectional view of a light emitting device in accordance with an embodiment of the present disclosure;
FIG. 2 is a graph illustrating a relation between the ratio of H2/H1 and the luminous efficiency of a light-emitting device according to some embodiments of the present disclosure;
FIG. 3 is a graph illustrating a relation between the ratio of H2/H1 and the maximum thickness H3 of a light-emitting device according to some embodiments of the present disclosure; and
FIG. 4 is a graph illustrating a relation between the ratio of H2/H1 and the maximum width H4 of a light-emitting device according to some embodiments of the present disclosure.

### DETAILED DESCRIPTION

It is to be noted that the following descriptions of preferred embodiments of this disclosure are presented herein for purpose of illustration and description only. It is not intended to be exhaustive or to be limited to the precise form disclosed. Also, it is also important to point out that there may be other features, elements, steps and parameters for implementing the embodiments of the present disclosure which are not specifically illustrated. Thus, the specification and the drawings are to be regard as an illustrative sense rather than a restrictive sense. Various modifications and similar arrangements may be provided by the persons skilled in the art within the spirit and scope of the present disclosure. In addition, the illustrations may not be necessarily be drawn to scale, and the identical elements of the embodiments are designated with the same reference numerals.

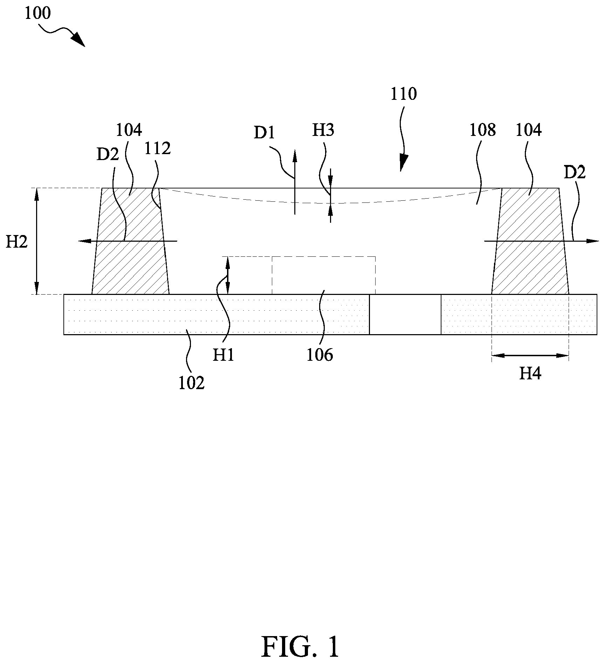

Referring to FIG. 1, which illustrates a cross-sectional view of a light emitting device 100 in accordance with an embodiment of the present disclosure. The light-emitting device 100 includes a circuit substrate 102, a surrounding wall 104, a light-emitting diode chip 106, a fluorescent resin 108 and a plate 110. In order to make the light-emitting device 100 to meet the light distribution shape and uniformity for the backlight module application, this disclosure focused on the relations among the various elements of the light-emitting device to find an appropriate relation to facilitate the mass production of a lighting device that meets the requirements. The wall 104 is formed on the circuit substrate 102 as a closed loop so as to collectively form the concave cup 112. The shape of the closed loop formed by the wall 104 (e.g., from the top view of the wall 104) can be rectangular, square, or circular. In some embodiments of the present disclosure, the wall 104 is (partially) transparent and (partially) reflective, in other words, the light emitted by the light emitting diode chip 106 can pass through the wall 104 in a lateral direction D2. In some embodiments, the light transmission rate of the wall of the light emitting device is greater than 30%. In some embodiments of the present disclosure, the wall 104 may have a height of H2 (microns). In some embodiments of the present disclosure, the wall 104 has a maximum width H4 (unit: millimeters, mm) Depending on the manufacture type of the wall 104, the thickness of the bottom side of the wall 104 is generally thicker than the top side and the maximum width H4 (millimeter) is generally on the bottom. The light emitting diode chip 106 is bonded to the surface of the circuit substrate 102 in the concave cup 112, and the light emitting diode chip 106 has a height of H1 (microns). In some embodiments of the present disclosure, the light emitting diode chip 106 could be a blue light emitting diode chip. The fluorescent resin 108 could be filled in the concave cup 112 to cover the light emitting diode chip 106. In some embodiments of the present disclosure, the fluorescent resin 108 could be a silicon-based material mixed with phosphors. In some embodiments of the present disclosure, the fluorescent resin 108 includes yellow fluorescent phosphors. The plate 110 is formed on the top surface of the fluorescent resin 108. In some embodiments of the present disclosure, the plate 110 has properties of light transmission and reflection. In other words, the light emitted by the light emitting diode chip 106 can pass through the plate 110 in an upward direction D1. In some embodiments of the present disclosure, the plate 110 has a maximum thickness H3 (microns), which can be the center thickness of the plate, and the thickness of the plate decreases from the center toward the edge of the wall 104. In some embodiments of the present disclosure, the plate 110 could be white and has a light transmission rate greater than 30%. Both the wall 104 and the plate 110 of the light emitting device 100 have properties of light transmission and reflection so the light output in the directions D1 and D2 can be adjusted for the light emitting device to meet the requirements.

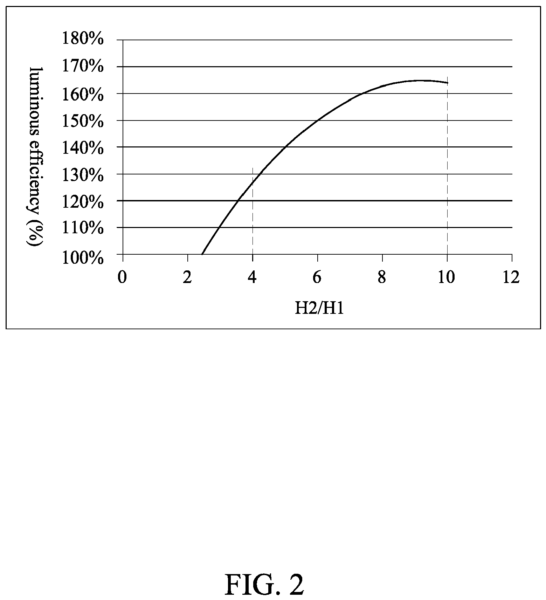

Referring to FIG. 2, which is a graph illustrating a relation between the ratio of H2/H1 and the luminous efficiency of a light-emitting device according to some embodiments of the present disclosure. Based on the study of the ratio of H2/H1 and the luminous efficiency of the light-emitting device 100, a function curve as shown in this figure is obtained, which indicates that the larger the ratio of H2/H1 is, the better the luminous efficiency of the light-emitting device 100 is. In other words, when the height (HI) of the light emitting diode chip 106 is a constant value, the greater the height H2 of the wall 104 is, the better the light emitting efficiency of the light emitting device 100 is. In case the wall 104 of the light emitting device 100 is opaque, the greater the height H2 of the wall 104 is, the worse the luminous efficiency of the light emitting device 100 is. The above ratio of H2/H1 is calculated with H2 and H1 having the same unit. In some embodiments of the present disclosure, when the ratio of H2/H1 ranges from 4 to 10, the luminous efficiency of the light emitting device 100 can meet the requirements of the backlight module application.

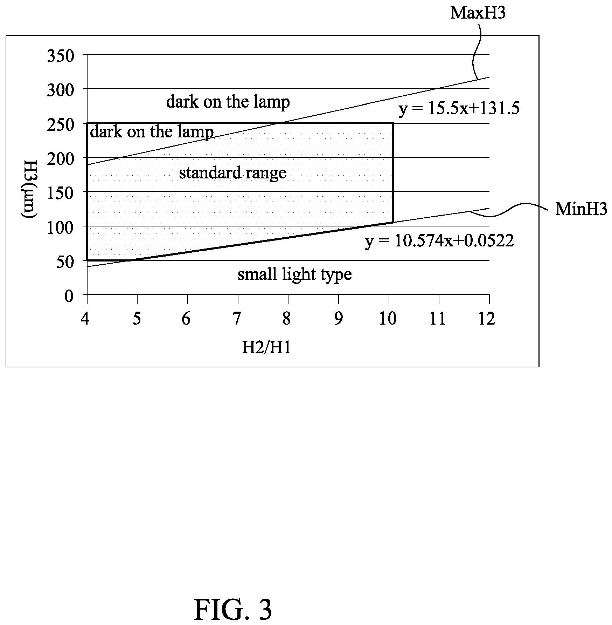

Referring to FIG. 3, which is a graph illustrating a relation between the ratio of H2/H1 (X axis) and the thickness of H3 (Y axis) in a light-emitting device according to some embodiments of the present disclosure. The influence of the maximum thickness H3 (microns) of the plate 110 on the uniformity of light emission of the light-emitting device is further studied and the relation shown in this figure is obtained accordingly. When the thickness H3 is less than 50 microns, the light distribution of the light emitting device 100 is relatively small. When the thickness H3 is greater than 200 microns, the "black shadow" is occurred in the light distributions of the light emitting device 100. Therefore, the value of H3 ranged between 50 and 250 microns can serve better to meet the requirement of the backlight module applications. For the H3 value to match the H2/H1 ratio, a functional relation H3 = A^{∗}(H2/H1) + B can be obtained. The numeral value of A ranges from about 10.5 to about 15.5 and the numeral value of B ranges from about 0.05 to about 131.5. When the H3 value is the largest, a line MaxH3 indicating the relation between H3(y) and H2/H1(x) satisfies the equation of y=15.5x+131.5. When the H3 value is the smallest, a line MinH3 indicating the relation between H3(y) and H2/H1(x) satisfies the equation of y=10.574x+0.0522. An intersection area (the dotted area labeled as "standard range") of the ratio range of H2/H1 (4 to 10), the area between the MaxH3 line and the MinH3 line, and the H3 value range (50 microns to 250 microns) is a range suitable for the light-emitting device 100 to meet the requirements of the applications.

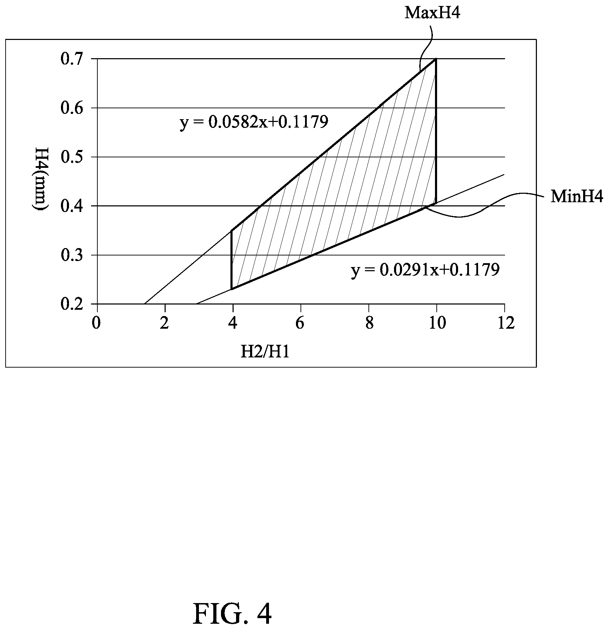

Referring to FIG. 4, which is a graph illustrating a relation between the ratio of H2/H1 and the width of H4 (millimeters) of the light-emitting device according to some embodiments of the present disclosure. The influence of the maximum width H4 (millimeters) of the wall 104 on the light emission uniformity of the light-emitting device is further studied and the relation as shown in this figure is obtained. For the H4 value to match the H2/H1 ratio, a functional relation H4 = C^{∗}(H2/H1) + 0.1179 is established with a value of C ranging from about 0.029 to about 0.058. When the H4 value is the largest, a line MaxH4 indicating the relation between H4(y) and H2/H1(x) satisfies the equation of y=0.0582x+0.1179. When the H4 value is the smallest, a line MinH4 indicating the relation between H4(y) and H2/H1(x) satisfies the equation of y=0.0291x+0.1179. An intersection area (marked by slashes in the figure) of the ratio range of H2/H1 (4-10) and the area between the MaxH4 line and the MinH4 line is a range suitable for the light emitting device 100 to meet the requirements of the applications.

When the light-emitting device disclosed herein is applied to a backlight module, by utilizing the relation between H2/H1 ratio and H3 or the relation between H2/H1 ratio and H4, the light-emitting device can be quickly manufactured with the sizes or production parameters that are obtained by such relations to meet the requirements of the backlight module, thereby improving the mass production efficiency.

## Claims

1. A light emitting device (100) comprising:
a substrate (102);
a wall (104) formed on the substrate (102), wherein a height of the wall (104) is H2;
a light-emitting diode chip (106) bonded on the substrate (102) and surrounded by the wall (104), wherein a height of the light-emitting diode chip (106) is H1;
a fluorescent resin (108) filled in the wall (104) and covering the light-emitting diode chip (106); and
a plate (110) covering the fluorescent resin (108) and a maximum thickness of the plate (110) is H3,
wherein H3 = A^{∗}(H2/H1) + B, and a value of A ranges from 10.5 to 15.5, a value of B ranges from 0.05 to 131.5.

2. A light emitting device (100) comprising:
a substrate (102);
a wall (104) formed on the substrate (102), wherein a height of the wall (104) is H2, and a maximum width of the wall (104) is H4;
a light-emitting diode chip (106) bonded on the substrate (102) and surrounded by the wall (104), wherein a height of the light-emitting diode chip (106) is H1;
a fluorescent resin (108) filled in the wall (104) and covered over the light-emitting diode chip (106); and
a plate (110) covering the fluorescent resin (108),
wherein H4 = C^{∗}(H2/H1) + 0.1179, and a value of C ranges from 0.029 to 0.058.

3. The light emitting device (100) of claim 1 or claim 2, wherein a ratio of H2/H1 ranges from 4 to 10.

4. The light emitting device (100) of claim 1 or claim 2, wherein the light-emitting diode chip (106) comprises a blue light-emitting diode chip.

5. The light emitting device (100) of claim 1 or claim 2, wherein the fluorescent resin (108) comprises yellow fluorescent phosphors.

6. The light emitting device (100) of claim 2, wherein a maximum thickness of the plate (110) is H3.

7. The light emitting device (100) of claim 1 or claim 6, wherein a value of H3 ranges from 50 to 250.

8. The light emitting device (100) of claim 1 or claim 6, wherein the maximum thickness of H3 is located at a center of the plate (110).

9. The light emitting device (100) of claim 8, wherein a thickness of the plate (110) decreases from the center of the plate (110) towards an edge of the wall (104).

10. The light emitting device (100) of claim 1 or claim 2, wherein the substrate (102) comprises a circuit substrate.

11. The light emitting device (100) of claim 1 or claim 2, wherein the wall (104) defines a concave cup (112).

12. The light emitting device (100) of claim 1 or claim 2, wherein the wall (104) and the plate (110) both have properties of light transmission and reflection, and a light transmission rate of the wall (104) or the plate (110) is greater than 30%.
